# EUROPÄISCHE PATENTSCHRIFT

(11) **EP 0 735 690 B1**
(45) Veröffentlichungstag und Bekanntmachung des Hinweises auf die Patenterteilung: **15.06.2005**
(21) Anmeldenummer: 96103412.1
(22) Anmeldetag: 05.03.1996
(51) Int. Cl.: H03L 5/02, H03G 3/20

(54) **Verfahren zur Leistungsregelung von Funkgeräten**
Method for controlling power of radio apparatuses
Méthode de réglage de la puissance d'appareils radio

(30) Priorität: 29.03.1995 DE 19511598
(43) Veröffentlichungstag der Anmeldung: 02.10.1996
(73) Patentinhaber: SIEMENS AKTIENGESELLSCHAFT, 80333 München (DE)
(72) Erfinder: Zeller, Gerhard, Dipl.-Ing., 80995 München (DE)

(56) Entgegenhaltungen:
- WO-A-93/02505
- DE-A- 3 433 901
- US-A- 5 192 919

## Beschreibung

Die Erfindung bezieht sich auf ein Verfahren zur Leistungsregelung von Funkgeräten mittels einer Regelschleife, bei dem eine Regelgröße mit einer von einem Sollwertgeber abgegebenen Führungsgröße verglichen und daraus eine Regelabweichung gebildet wird. Ein solches Verfahren ist beispielsweise aus der DE 34 33 901 C2 bekannt.

Sendeleistungsregelungen in Funkgeräten dienen dazu, wählbare Sendeleistungsstufen einstellbar zu machen und diese konstant zu halten. Die üblichen Sendeleistungsregelungen werden so eingestellt, daß im ungünstigsten Fall, bei extremer, aber noch zulässiger Betriebsspannung und Umgebungstemperatur eine Überschreitung des Regelbereiches vermieden wird. Das bedeutet eine Einstellung auf die niedrigste für diese Extrembedingungen mögliche Sendeleistung, die dann aber auch bei Normalbedingungen, wenn an sich höhere Leistungen möglich und wünschenswert wären, eingehalten wird.

In den Empfehlungen für ein GSM (Groupe Special Mobile) Mobilfunkgerät der 2W-Klasse werden beispielsweise insgesamt elf Sendeleistungsstufen gefordert, die innerhalb der geforderten Toleranzen für Normalbedingung und für Extrembedingung eingehalten werden müssen. Die Toleranzen für Extrembedingungen sind dabei immer größer als die für Normalbedingungen. Die Umgebungstemperatur z.B. beträgt +15°C...+35°C für Normalbedingung und -20°C...+55°C für Extrembedingungen. Hierbei ist zu beachten, daß die höchste Leistungsstufe die maximale Reichweite des Funkgerätes bestimmt und deshalb die negativen Toleranzen möglichst vermieden werden.

Aus der WO 93/02505 ist ein Verfahren zur Leistungsregelung von Funkgeräten mittels einer Regelschleife bekannt, bei dem eine Regelgröße mit einer von einem Sollwertgeber abgegebenen Führungsgröße verglichen, daraus eine Regelabweichung gebildet wird, wobei Temperatur und Betriebsspannung als Störgrößen in den Regelkreis einbezogen werden.

Der Erfindung liegt die Aufgabe zugrunde, mit einem Verfahren zur Leistungsregelung die Höhe der Sendeleistung an die genannten wechselnden Bedingungen der Betriebsspannung und Temperatur anpaßbar zu machen.

Diese Aufgabe wird mit einem Verfahren gemäß Anspruch 1 gelöst.

Durch die erfindungsgemäßen Maßnahmen zur Anpassung der Höhe der Sendeleistung an die wechselnden Bedingungen der Betriebsspannung und Temperatur wird zugleich bei der höchsten Leistungsstufe immer die jeweils höchstmögliche Sendeleistung innerhalb zulässiger Toleranzen erreicht. Die Anpassung hat u.a. den Vorteil, daß auch leistungsschwächere und somit billigere Module eingesetzt werden können, wenn bei den normalen Bedingungen gegenüber den extremen Bedingungen eine höhere maximale Leistung und damit eine maximale Funkreichweite erreicht werden soll.

Vorteilhafte Ausgestaltungen und Weiterbildungen des Erfindungsgegenstandes sind in dem Unteranspruch angegeben.

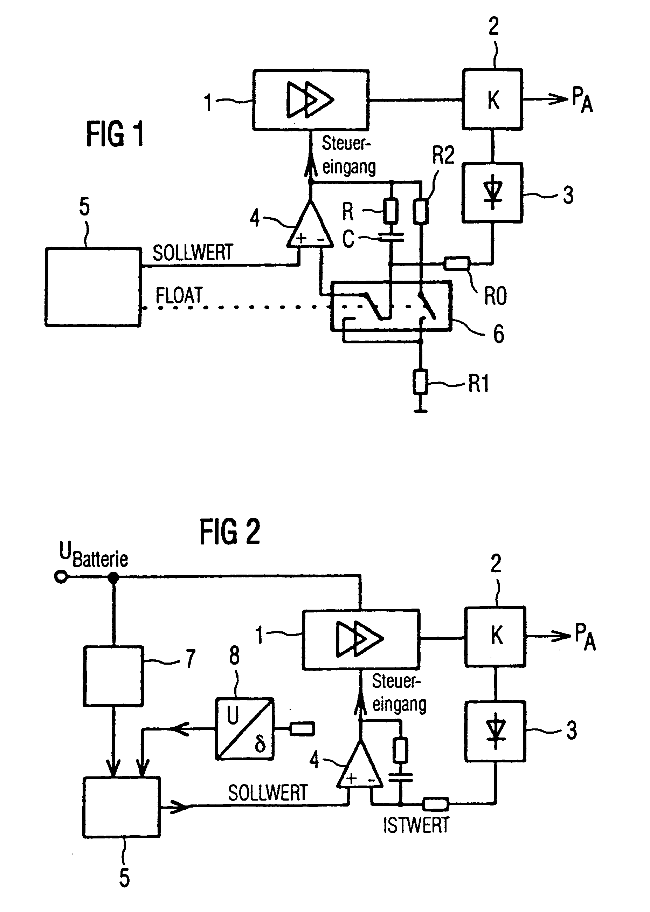

Nachstehend wird die Erfindung anhand von in der Zeichnung dargestellten Ausführungsbeispielen näher erläutert, wobei das Ausführungsbeispiel nach Fig. 2 nicht zu der Erfindung sondern zum Stand der Technik gehört.

Fig. 1 zeigt eine Sendeleistungsregelung im Blockschaltbild mit einem Sender 1 und einem nachfolgenden Richtkoppler 2 im Übertragungsweg sowie einem Gleichrichter 3, dem der vom Richtkoppler 2 ausgekoppelte Teil der Ausgangsleistung P_{A} zugeführt wird und dessen Ausgangsspannung die Regelgröße (Istwert) bildet. Die Regelgröße wird in einem PI-Regler 4 mit einer von einer Steuerung 5 abgegebenen Führungsgröße (Sollwert) verglichen und daraus die Regelgröße gebildet. Diese wird einem Steuereingang des Senders 1 zugeführt.

Die Regelung für alle Leistungsstufen wird bei der erfindungsgemäßen Schaltung für die höchste Leistungsstufe unterbrochen und durch eine Leistungssteuerung ersetzt, indem der Regler zu einem 2:1 Verstärker umgeschaltet wird. Die Leistung wird dann auf einen Wert eingestellt, der über die Störgrößen Betriebsspannung und Temperatur innerhalb der vorgegebenen Toleranzgrenzen variieren kann. Voraussetzung für die Unterbrechung der Regelung ist, daß die genannten Störgrößen nur so wenig eingehen, daß die erlaubten Toleranzen nicht überschritten werden.

Für die Umschaltung sind zwei elektronische Schalter vorgesehen, die innerhalb des Blocks 6 angeordnet sind sowie zwei Widerstände R1 und R2. Der eine, als Umschalter ausgebildete Schalter ist mit seinem Mittelanschluß an den einen Eingang des Reglers 4 angeschlossen, dessen anderem Eingang der Sollwert zugeführt wird, von den beiden Umschaltkontakten ist der eine über einen Widerstand R0 an den Ausgang des Gleichrichters 3 sowie über einen Kondensator C und einen Widerstand R an den Steuereingang des Verstärkers 1 angeschlossen (in der Zeichnung dargestellte Schalterstellung) und der andere über einen Widerstand R1 an Masse gelegt. Der zweite, in der Darstellung geöffnete Schalter liegt mit einem Anschluß über den Widerstand R1 an Masse, mit dem zweiten Anschluß über einen Widerstand R2 am Steuereingang des Verstärkers 1. Beide Schalter werden von einem Float-Signal der Steuerung 5 angesteuert. Bei der in der Figur gezeigten Schalterstellung schließt der Umschalter den Verbindungsweg vom Ausgang des Gleichrichters 3 zum Eingang des Reglers 4, während der zweite Schalter geöffnet ist.

Durch diese Leistungssteuerung kann nun bei der höchsten Leistungsstufe die Toleranz für Extrembedingungen ausgenutzt werden. Es können so also Module eingesetzt werden, die bei Extrembedingungen gerade die Leistungsanforderung erfüllen und bei Normalbedingungen reichlich Ausgangsleistung zur Verfügung stellen.

Die zum Stand der Technik gehörende Schaltung nach Fig. 2 entspricht in ihrem Grundaufbau der gemäß Fig. 1, indem sie einen Verstärker 1, einen Richtkoppler 2, einen Gleichrichter 3, einen Regler 4 sowie eine Steuerung 5 enthält. Unterschiedlich ist hierbei das Fehlen der Schalter und der in Verbindung mit den Schaltern vorgesehenen Widerstände R1 und R2, hingegen sind hierbei ein Spannungssensor 7 und ein Temperatursensor 8 vorgesehen, die an zwei Eingänge der Steuerung 5 angeschlossen sind. Der Spannungssensor 7 ist zudem mit der Batteriespannung verbunden.

Die Steuerung führt bei der größten Leistungsklasse den Sollwert und damit die Ausgangsleistung in Abhängigkeit der Betriebsspannung und der Temperatur so nach, daß die Toleranzen für Normalbedingungen und für Extrembedingungen ausgenutzt werden. Die Regelung bleibt dabei weiterhin aktiv. Es können so auch hier Module eingesetzt werden, die bei Extrembedingungen gerade die Leistungsanforderung erfüllen und bei Normalbedingungen reichlich Ausgangsleistung zur Verfügung stellen. Die hierfür vorgesehenen Auswerteschaltungen mit dem Spannungssensor 7 und dem Temperatursensor 8 melden die aktuellen Größen der Betriebsspannung und Temperatur an die Steuerung 5.

Ein großer Vorteil der erfindungsgemäßen Maßnahmen besteht in einer höheren Ausgangsleistung und damit größeren Reichweite des Funkgerätes bei Normalbedingungen.

## Patentansprüche

1. Verfahren zur Leistungsregelung von Funkgeräten mittels einer Regelschleife,
bei dem eine Regelgröße mit einer von einem Sollwertgeber abgegebenen Führungsgröße verglichen und daraus eine Regelabweichung gebildet wird,
bei dem Temperatur und Betriebsspannung als Störgrößen in die Regelschleife einbezogen sind,
**dadurch gekennzeichnet, dass**
die Regelung durch eine Umschaltung in mehrere Leistungsstufen derart erfolgt,
dass die für alle Leistungsstufen vorgesehene Regelung für die höchste Leistungsstufe unterbrochen und durch eine Leistungssteuerung ersetzt wird, indem ein zur Bildung der Regelabweichung vorgesehener Regler zu einem Verstärker umgewandelt und die Leistung auf einen über die Störgrößen Betriebsspannung und Temperatur innerhalb von vorgegebenen Toleranzgrenzen variablen Wert eingestellt wird.

2. Verfahren nach Anspruch 1, **dadurch gekennzeichnet, dass**
die Umschaltung über in die Regelschleife vor dem Istwert-Eingang des Reglers eingeschaltete Schalter erfolgt.

## Claims

1. A method for controlling the power of radio equipment by means of a control loop, wherein a controlled variable is compared with a reference variable output by a setpoint generator and from this a control deviation is formed,
wherein temperature and operating voltage are included in the control loop as disturbance variables,
**characterised in that**
the closed-loop control is carried out by means of a changeover to several power levels such that the closed-loop control provided for all power levels is interrupted for the highest power level and is replaced by a power control in which a controller provided for forming the control deviation is converted to an amplifier and the power is set to a value which can be varied within predetermined tolerance limits by means of the disturbance variables of operating voltage and temperature.

2. A method according to Claim 1, **characterised in that** the changeover is carried out by means of switches connected to the control loop before the actual-value input of the controller

## Revendications

1. Procédé pour le réglage de la puissance d'appareils radio au moyen d'une boucle de réglage,
dans lequel une grandeur de réglage est comparée à une grandeur de référence sortie par un émetteur de valeurs théoriques et de cela un écart de réglage est formé,
dans lequel la température et la tension de service sont incluses dans la boucle de réglage comme grandeurs perturbatrices,
**caractérisé en ce que**
le réglage est réalisé au moyen d'une commutation en plusieurs étages de puissance, de telle manière
que le réglage prévu pour tous les étages de puissance est interrompu pour l'étage de puissance le plus élevé et est remplacé par une commande de puissance, du fait qu'un régulateur prévu pour la formation de l'écart de réglage est transformé en un amplificateur et que la puissance est réglée sur une valeur variable par l'intermédiaire des grandeurs perturbatrices, tension de service et température, dans des limites de tolérance prédéfinies.

2. Procédé selon la revendication 1, **caractérisé en ce que** la commutation est réalisée par l'intermédiaire de commutateurs mis en circuit dans la boucle de réglage en amont de l'entrée de la valeur réelle du régulateur.
